# EUROPÄISCHE PATENTSCHRIFT

(11) **EP 0 342 495 B1**
(45) Veröffentlichungstag und Bekanntmachung des Hinweises auf die Patenterteilung: **12.01.1994**
(21) Anmeldenummer: 89108372.7
(22) Anmeldetag: 10.05.1989
(51) Int. Cl.: G03F 7/004

(54) **Strahlungsempfindliches Gemisch und Verfahren zur Herstellung von Reliefmustern**
Light-sensitive composition and process for the formation of relief patterns
Composition photosensible et procédé pour la fabrication d'images en relief

(30) Priorität: 19.05.1988 DE 3817009
(43) Veröffentlichungstag der Anmeldung: 23.11.1989
(73) Patentinhaber: BASF Aktiengesellschaft, 67063 Ludwigshafen (DE)
(72) Erfinder: Schwalm, Reinhold, Dr., D-6706 Wachenheim (DE); Binder, Horst, D-6840 Lampertheim (DE); Boettcher, Andreas, Dr., D-6907 Nussloch (DE)

(56) Entgegenhaltungen:
- EP-A- 0 102 450
- DE-A- 3 628 046
- JP-A-62 038 450
- JOURNAL OF IMAGING TECHNOLOGY. vol. 11, no. 4, August 1985, SPRINGFIELD US Seiten 146 - 157; S.P.Papas: "Photogeneratiom of Acid : Part 6 - A Review of Basic Principles for Resist Imaging Applications "

## Beschreibung

Die Erfindung betrifft positiv arbeitende strahlungsempfindliche Gemische, die ein wäßrig-alkalisch lösliches polymeres Bindemittel, das hydrophobe Comonomereinheiten mit säurelabilen Gruppierungen enthält, und eine Verbindung, die mindestens eine durch Säure spaltbare Bindung enthält und unter Einwirkung von Strahlung eine starke Säure bildet, wobei die Löslichkeit der Verbindung in einem alkalischen Lösungsmittel durch die Einwirkung der Säure erhöht wird, enthalten. Diese Gemische sind sensitiv gegenüber UV-, Elektronen- und Röntgenstrahlen und eignen sich besonders als Resistmaterialien.

Positiv arbeitende strahlungsempfindliche Gemische sind bekannt. Besonders positiv arbeitende Resistmaterialien, die o-Chinondiazide in wäßrigalkalisch löslichen Bindemitteln, z.B. Novolaken oder Poly-(p-vinyl-phenol)en, enthalten, werden kommerziell eingesetzt. Die Empfindlichkeit dieser Systeme gegenüber Strahlung, insbesondere kurzwelliger Strahlung, ist jedoch teilweise unbefriedigend.

Empfindlichkeitserhöhungen in strahlungsempfindlichen Systemen, die in der Primärphotoreaktion eine Spezies erzeugen, die dann unabhängig von der Strahlung eine katalytische Sekundärreaktion auslöst, sind ebenfalls beschrieben. Die US-A-3 915 706 betrifft beispielsweise Photoinitiatoren, die eine starke Säure erzeugen, die dann in einer Sekundärreaktion säurelabile Gruppen, wie Polyaldehydgruppierungen spaltet.

Weiterhin sind strahlungsempfindliche Gemische auf Basis von säurespaltbaren Verbindungen bekannt, die als Bindemittel ein wäßrig-alkalisch lösliches Polymer, sowie eine Verbindung, die photochemisch eine starke Säure bildet und eine weitere Verbindung mit durch Säure spaltbaren Bindungen, die durch die Einwirkung der Säure ihre Löslichkeit in einem alkalischen Entwickler erhöhen, enthalten (DE-A-3 406 927). Als photochemisch eine starke Säure bildende Verbindungen werden Diazonium-, Phosphonium-, Sulfonium- und Iodonium-, sowie Halogenverbindungen genannt. Die Verwendung dieser Oniumsalzen als photochemische Säurespender in Resistmaterialien ist z.B. auch aus US-A-4 491 628 bekannt. Einen Überblick über die Anwendung von Oniumsalzen in Resistmaterialien gibt Crivello in "Org. Coatings and Appl. Polym. Sci.", 48, Seiten 65-69 (1985). Nachteilig bei diesen Photoinitiatoren ist, daß sie durch die Einwirkung der Strahlung nicht so verändert werden, daß eine Erhöhung der Löslichkeit im alkalischen Entwickler resultiert. Weiterhin benötigen diese Gemische zwingend drei Komponenten.

Strahlungsempfindlicne Gemische von Polymeren mit säurelabilen Seitengruppen und photochemischen Säurespendern sind z.B. aus US-A-4 491 628 und FR-A-2 570 844 bekannt. Diese polymeren Bindemittel sind jedoch hydrophob und werden erst nach der Belichtung alkalilöslich. Außerdem ist nachteilig, daß bei der Umwandlung von hydrophob nach alkalilöslich ein großer Massenverlust auftritt.

Copolymere mit phenolischen und säurelabilen Gruppen, wie beispielsweise Poly-(p-hydroxistyrol-co-t-butoxicarbonyloxistyrol), sind aus "J. Polym. Sci., Part A, Polym. Chem. Ed, ", Vol. 24, 2971-2980 (1986) bekannt. Verwendet man jedoch diejenigen Copolymeren dieser Gruppe, die noch alkalilöslich sind, in Verbindung mit den kommerziellen Sulfoniumsalzen, wie Triphenylsulfoniumhexafluoroarsenat, wie auch in US-A-4 491 628 beschrieben, so haben diese Gemische den Nachteil, daß ein sehr hoher Abtrag der unbelichteten Bereiche stattfindet, da die genannten Sulfoniumsalze nicht genügend zur Löslichkeitsinhibierung beitragen. Weiterhin tragen diese Salze nach der Belichtung nur wenig zur Löslichkeitserhöhung der bestrahlten Bereiche in alkalischen Entwicklern bei, da außer den gebildeten Säuren keine alkalilöslichen Photoprodukte entstehen.

In DE-A-37 21 741 werden strahlungsempfindliche Gemische vorgeschlagen, die ein in wäßrig-alkalischen Lösungen lösliches polymeres Bindemittel enthalten sowie eine organische Verbindung, deren Löslichkeit in einem wäßrig-alkalischen Entwickler durch Einwirkung von Säure erhöht wird und die mindestens eine durch Säure spaltbare Gruppierung enthält, wobei diese organische Verbindung unter Einwirkung von Strahlung eine starke Säure erzeugt. Fur bestimmte Anwendungszwecke haben diese Systeme jedoch Nachteile. Beispielsweise hat in diesen Systemen die organische Verbindung zwei Aufgaben, nämlich die Löslichkeit des polymeren Bindemittels vor der Belichtung zu reduzieren und nach der Belichtung zu erhöhen und zweitens muß die Verbindung strahlungsempfindlich sein. Für bestimmte Anwendungen ist es jedoch vorteilhaft, den Anteil der photoaktiven organischen Verbindung zu reduzieren, z.B. um eine höhere Transparenz im kurzwelligen UV-Gebiet (im Bereich um 250 nm) zu erhalten, so daß die Aufgabe der Löslichkeitsinhibierung anders gelöst werden muß.

In der EP-A-0 249 139 werden Resist-Zusammensetzungen beschrieben, die ein in Wasser oder in wäßrigen Basen lösliches organisches Polymer, eine säurelabile Gruppe enthaltende Verbindung, die ein Löslichkeitsinhibitor für das wasserlösliche Polymer ist, beispielsweise eine tert.-Butylesterverbindung und ein Aryloniumsalz, wie z.B. ein Arylsulfonium- oder Aryljodoniumsalz enthalten. Das hierin beschriebene organische Polymere ist ein Novolak mit einem mittleren Molekulargewicht Mw von 200 bis 20.000. Der Nachteil dieser Resistzusammensetzungen ist ihre geringe Transparenz im Wellenlängenbereich von unterhalb 300 nm sowie die geringe thermische Stabilität, bedingt durch die Verwendung der relativ niedermolekularen Novolake. In der EP-A-0 146 411 werden photosolubilisierbare Gemische beschrieben, die aus einem alkalilöslichen Phenolharz, speziell Novolak- oder Resolharz, und einem strahlungsempfindlichen Oniumsalz bestehen. Nachteile dieser Gemische sind ihre geringe Lichtempfindlichkeit, ihre geringe Transparenz im Wellenlängenbereich unterhalb 300 nm und ihre geringer Verarbeitungspielraum. Beispielsweise ist ein Ausheizen nach der Belichtung, wie es in der Technik üblicherweise zur Verringerung der Effekte der stehenden Wellen angewandt wird, nicht möglich, da dann die Gemische zur Vernetzung neigen.

Aufgabe der vorliegenden Erfindung ist es, hochreaktive strahlungsempfindliche Systeme für die Herstellung von Reliefstrukturen zur Verfügung zu stellen, die sich mit wäßrig-alkalischen Lösungen entwickeln lassen und die die Herstellung von lichtempfindlichen Schichten mit hoher Transparenz im kurzwelligen UV ermöglichen.

Gegenstand der vorliegenden Erfindung ist ein strahlungsempfindliches Gemisch, enthaltend
(a) ein in Wasser unlösliches, in wäßrig-alkalischen Lösungen lösliches polymeres Bindemittel und
(b) eine monomere organische Verbindung, deren Löslichkeit in einem wäßrigalkalischen Entwickler durch Einwirkung von Säure erhöht wird, und die mindestens eine durch Säure spaltbare Gruppierung sowie zusätzlich eine Gruppierung, die unter Einwirkung von Strahlung eine starke Säure bildet, enthält,
das dadurch gekennzeichnet ist, daß das polymere Bindemittel (a) 5 bis 35 Mol.% Monomereneinheiten mit säurelabilen Gruppierungen einpolymerisiert oder einkondensiert, oder die säurelabilen Gruppierungen durch polymeranaloge Umsetzung eingeführt enthält, wobei als säurelabilen Gruppierungen tert. -Butylester-, t-Butylcarbonat- und/oder Silylethergruppierungen bevorzugt sind, wobei Gruppierungen 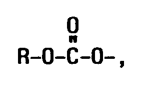
worin R 5 bis 9 Kohlenstoffatome enthält, ausgenommen sind.

Als polymere Bindemittel a) kommen sowohl säurelabile Gruppierungen enthaltende phenolische Harze, wie z.B. Novolake, Poly- (p-hydroxistyrole), Poly-(p-hydroxi-α-methylstyrole) oder Copolymere von p-Hydroxistyrol oder p-Hydroxi-α-methylstyrol, die die oben genannten säurelabilen Gruppierungen enthalten, als auch Copolymerisate mit Carboxylgruppen, wie z.B. Methylmethacrylat/Methacrylsäure/t-Butylmethacrylat-Copolymerisate in Betracht.

Als monomere organische Verbindungen (b) sind solche bevorzugt, welche mindestens eine Sulfoniumsalzgruppierung und mindestens eine t-Butylcarbonatgruppierung oder mindestens eine Silylethergruppierung enthalten. Es können jedoch auch andere Verbindungen verwendet werden, welche unter Bestrahlung eine starke Säure bilden und im gleichen Molekül eine säurespaltbare Bindung enthalten.

Bevorzugte derartige organische Verbindungen (b) sind solche der allgemeinen Formel (I) 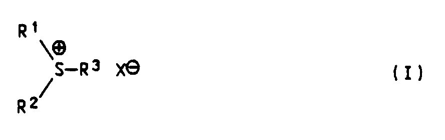
worin R¹, R² und R³ untereinander gleich oder verschieden sind und für aliphatische und/oder aromatische Reste, die gegebenenfalls Heteroatome enthalten, stehen oder zwei der Reste R¹ bis R³ miteinander zu einem Ring verknüpft sind, mit der Maßgabe, daß mindestens einer der Reste R¹ bis R³ mindestens eine durch Säure spaltbare Gruppierung enthält, wobei einer der Reste R¹ bis R³ mit einem oder mehreren weiteren Sulfoniumsalzresten, gegebenenfalls über durch Säure abspaltbare Gruppierungen, verknüpft sein kann, und X^{⊖} ein nichtnukleophiles Gegenion bedeutet, beispielsweise ein Dimethyl-4-t-butoxicarbonyloxiphenyl-sulfoniumsalz, ein Phenyl-bis-(4-t-butoxicarbonyl-oxiphenyl-)sulfoniumsalz, ein Tris-(4-t-butoxicarbonyloxiphenyl-)-sulfoniumsalz oder ein 1-Naphthyl-4-trimethylsilyloxitetramethylen-sulfoniumsalz mit Hexafluoroarsenat, Hexafluoroantimonat, Hexafluorophosphat und/oder Tetrafluoroborat als Gegenion ist.

Besonders bevorzugte derartige organische Verbindungen (b) sind solche der allgemeinen Formel (II) 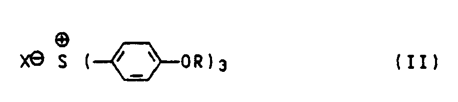
worin R = H, t-Butoxycarbonyl- und/oder Trialkylsilyl- sein kann, mit der Maßgabe, daß mindestens einer der Reste R 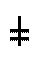 Wasserstoff ist.

Gegenstand der vorliegenden Erfindung ist auch ein Verfahren zur Herstellung von Reliefmustern und Reliefbildern, wozu das erfindungsgemäße strahlungsempfindliche Gemisch eingesetzt wird, wobei nach der Belichtung ein Erhitzen auf Temperaturen zwischen 60 und 120°C bevorzugt wird.

Zu den Aufbaukomponenten des erfindungsgemäßen strahlungsempfindlichen Gemisches ist im einzelnen folgendes auszuführen.

### Polymeres Bindemittel (a)

Als Novolake kommen solche in Frage, wie sie z.B. in "Novolak Resins Used in Positiv Resist Systems" von T. Pampalone in "Solid State Technology, June 1984, Seite 115-120, beschrieben sind. Für spezielle Anwendungen, z.B. für Belichtung im kurzwelligen UV-Gebiet kommen bevorzugt Novolake aus p-Kresol und Formaldehyd in Frage. Diese Novolake können dann zur Herstellung der erfindungsgemäß einzusetzenden Komponente (a) mit Di-t-butyl-dicarbonat in Gegenwart von Kalium-t-butylat in beispielsweise Tetrahydrofuran so umgesetzt werden, daß bis zu 30 mol.% der phenolischen Gruppen umgesetzt werden.

Weiterhin als Grundlage für (a) geeignete alkalilösliche Polymere können nach gängigen Methoden durch radikalische oder ionische Homo- oder Copolymerisation aus einem oder mehreren ethylenisch ungesättigten Monomeren hergestellt werden. Ethylenisch ungesättigte Komponenten, welche homo- oder copolymerisiert werden können, sind beispielsweise substituierte und unsubstituierte Styrole, wie p-Hydroxistyrol, p-t-Butoxicarbonyloxistyrol, p-Vinyl-benzoesäure, p-Vinylbenzoesäure-t-butylester, p-Hydroxi-α-methyl-styrol, C₁- bis C₆-Alkylacrylate und C₁- bis C₆-Alkylmethacrylate, wie t-Butylacrylate und/oder -methacrylate, Acrylsäure und Methacrylsäure.

Bevorzugt sind Copolymerisate aus p-Hydroxistyrol, die 5 bis 35, vorzugsweise 10 bis 30 % Monomere mit säurelabilen Gruppierungen einpolymerisiert enthalten.

Derivate von Poly-(p-hydroxistyrol) können ebenfalls nach der von H. Ito in "J. of Polym. Sci.: Part A: Polym. Chem. Ed., Vol. 24, 2971 bis 2980 (1986)" beschriebenen Methode aus Poly-(p-t-butoxicarbonyloxistyrol), welches in Poly-(p-hydroxistyrol) umgewandelt und dann mit den entsprechenden Mengen Di-t-butyl-dicarbonat umgesetzt wird, hergestellt werden. Poly-(p-hydroxistyrole) können aber auch teilweise zu Silylethern umgesetzt werden, beispielsweise mit Hexamethyl-disilazan.

Bevorzugte polymere Bindemittel (a) sind insbesondere solche, die t-Butylcarbonat-Gruppierungen enthalten, beispielsweise Copolymere aus p-Hydroxistyrol und 10 bis 30 Mol.% p-t-Butoxicarbonyloxistyrol.

Die Synthese der Copolymeren kann durch radikalische Polymerisation der entsprechenden Monomeren, beispielsweise p-Hydroxistyrol und p-t-Butoxicarbonyloxistyrol, Hydroxystyrol und Trimethylsilyloxistyrol bzw. p-Hydroxistyrol und t-Butyl-methacrylat, nach bekannten Methoden der Polymerchemie erfolgen oder durch polymeranaloge Umsetzung von Poly-(p-hydroxistyrol) mit den entsprechenden Verbindungen zur Einführung der säurelabilen Gruppen in entsprechenden Mengen.

Die Copolymere von p-Hydroxistyrol und p-t-Butoxicarbonyloxistyrol sind beispielsweise in "J. Polym. Sci.: Part A: Polym. Chem, Ed." Vol. 24, Seiten 2971-2980 (1986) beschrieben. Sie werden aus Poly-(p-hydroxistyrol) durch Umsetzung mit der entsprechenden Menge Di-t-butyl-dicarbonat hergestellt.

Copolymere von p-Hydroxistyrol mit Trimethylsilyloxistyrol lassen sich z.B. durch Umsetzung von Poly-(p-hydroxystyrol) mit der entsprechenden stöchiometrischen Menge Hexamethyldisilazan durch Erhitzen bis zu 100°C, gegebenenfalls in Gegenwart eines inerten Lösungsmittels, wie Ethylacetat oder Pentanon, herstellen,

Die Zusammensetzung der Copolymeren wurde durch thermogravimetrische Analyse und H-NMR-Spektroskopie bestimmt.

Die Erfindung ist nicht auf die hier erwähnten Copolymeren beschränkt, vielmehr können eine Reihe von alkalilöslichen Copolymere von p-Hydroxistyrol verwandt werden, bevorzugt sind jedoch solche, die als weitere Comonomereinheit ein p-Hydroxistyrolderivat enthalten, welches über die phenolische OH-Gruppe solche säurelabilen Gruppierungen gebunden enthält, die durch die Einwirkung von Säure die phenolische OH-Gruppe zurückbilden.

Als polymere Bindemittel (a) kommen bevorzuzgt alkalisch lösliche Bindemittel mit einem hohen Anteil aromatischer Gruppen in Betracht, wie beispielsweise Novolake oder Poly-(p-hydroxistyrole). Die Absorption von Novolaken bei einer Wellenlänge von 254 nm ist beispielsweise:

| | | | |
|---|---|---|---|
| Novolake auf Basis | o-Kresol | Optische Dichte | 0,48/µm |
| | m-Kresol | | 0,46/µm |
| | p-Kresol | | 0,28/µm |

Dazu addiert sich die Absorption der organischen Verbindungen (b). Beispielsweise haben Verbindungen wie Phenyl-bis-(t-butoxicarbonyloxiphenyl-) sulfoniumhexafluoroarsenat oder Tris-(t-butoxicarbonyloxiphenyl-)sulfoniumhexafluoroarsenat in diesem Wellenlängenbereich um 250 nm Extinktionskoeffizienten größer 5 000 l/mol·cm.

Um eine Löslichkeitsinhibierung durch diese Komponenten zu erhalten, muß man jedoch deutlich mehr als 10 Gew.% dieser Verbindungen zum Bindemittel geben, wenn man nichtumgesetzte Novolake oder Poly-(p-ydroxistyrole) einsetzt, so daß sich optische Dichten im Bereich um 1/µm Schichtdicke oder höher ergeben.

Erfindungsgemäß läßt sich der Anteil der Verbindungen (b) reduzieren, wenn man alkalilösliche Bindemittel mit bis zu 30 mol.% hydrophoben Monomeren mit säurelabilen Gruppierungen verwendet. Durch die Einwirkung von Strahlung wird von der Verbindung (b) eine starke Säure erzeugt, die sowohl die Löslichkeit der Verbindung (b) in alkalischen Entwicklern erhöht, als auch zusätzlich die Löslichkeit des polymeren Bindemittels erhöht, indem die säurelabilen Gruppen abgespalten werden. In den belichteten Bereichen entstehen also durch die Einwirkung der Strahlung alkalilösliche Produkte aus den photoempfindlichen Verbindungen (b), und die Löslichkeit des Polymeren wird ebenfalls erhöht, so daß eine Löslichkeitsdifferenzierung durch Belichtung erhalten wird.

Vergleicht man zwei Resistzusammensetzungen, die keinen Abtrag der unbelichteten Bereiche zeigen, so kann durch die Verwendung dieser speziellen alkalilöslichen Bindemittel die optische Dichte im Wellenlängenbereich um 250 nm wesentlich verbessert werden:

| | |
|---|---|
| Poly-(p-hydroxistyrol) + 20 Gew.% Tris-(t-butoxicarbonyloxiphenyl-)sulfoniumhexafluoroarsenat | OD (248 nm) 0,95/µm |
| Poly-(p-hydroxistyrol-co-t-butoxicarbonyloxistyrol) + 10 Gew.% Tris-(t-butoxicarbonyloxiphenyl-)sulfoniumhexafluoroarsenat | OD (248 nm) 0,54/µm |

Hohe optische Dichten wirken sich negativ auf das Flankenprofil aus.

Möglichkeiten für die Synthese der organischen Verbindungen (b) sind in DE-A-3 721 741 bzw. DE-A-3 721 740 angegeben.

Die erfindungsgemäßen strahlungsempfindlichen Gemische sind sensitiv gegenüber Röntgen-, Elektronen- und UV-Strahlung. Gegebenenfalls können Sensibilisatoren in geringen Mengen zugesetzt werden, wie beispielsweise Pyren und Perylen, um die Verbindungen im längerwelligen UV- bis hin zum sichtbaren Wellenlängenbereich zu sensibilisieren. Für die Belichtung in speziellen Wellenlängenbereichen, wie beispielsweise im kurzwelligen UV (< 300 nm), ist eine hohe Transparenz der Schichten bei der jeweiligen Belichtungswellenlänge gefordert. In gängigen Belichtungsgeräten auf Basis von Quecksilberlampen nutzt man üblicherweise die 254 nm Linie oder man verwendet Excimer-Laser, die bei 248 nm (KrF) emittieren. Strahlungsempfindliche Aufzeichnungsmaterialien sollten deshalb in diesem Bereich möglichst niedrige optische Dichten aufweisen.

Bei dem erfindungsgemäßen Verfahren zur Herstellung von Reliefmustern wird eine strahlungsempfindliche Aufzeichnungsschicht, die im wesentlichen aus dem erfindungsgemäßen strahlungsempfindlichen Gemisch besteht, bildmäßig in solcher Dosis bestrahlt, daß die Löslichkeit der belichteten Bereiche nach einem thermischen Ausheizschritt bei Temperaturen zwischen 60°C und 120°C in wäßrig-alkalischen Lösungsmitteln zunimmt und diese Bereiche selektiv mit dem alkalischen Entwickler entfernt werden können.

Vorzugsweise wird z.B. das polymere Bindemittel (a), welches zwischen 5 und 30 mol.% Monomerkomponente mit säurelabilen Gruppen enthält, und zwischen 2 und 15 Gew.%, besonders bevorzugt zwischen 5 und 10 Gew.% einer Verbindung des Typs (b), bezogen auf das Gesamtgewicht der Verbindungen (a) und (b), in Methylglykolacetat oder Methyl-propylenglykol-acetat gelöst, wobei der Feststoffgehalt zweckmäßigerweise zwischen 10 und 30 Gew.% beträgt. Die Lösung kann durch ein Filter mit einem Porendurchmesser von 0,2 µm filtriert werden. Durch Aufschleudern der so erhaltenen Resistlösung bei Umdrehungszahlen zwischen 1000 und 10 000 U/min wird ein Resistfilm auf dem Wafer erzeugt. Der Hafer wird dann zweckmäßigerweise zwischen 1 und 5 Minuten bei 90°C bzw. 80°C ausgeheizt. Die Filme werden im allgemeinen durch eine chrombeschichtete strukturierte Quarzmaske mit UV-Licht einer Quecksilberlampe, mit Excimer-Laserlicht, Elektronen- oder Röntgenstrahlen bestrahlt. Die bestrahlten Filme werden zwischen 5 Sekunden und 2 Minuten bei Temperaturen zwischen 60 und 120°C ausgeheizt. Die so behandelten Filme werden hierauf mit alkalischen, gegebenenfalls Alkohole enthaltenden Entwicklern entwickelt, wobei sich die belichteten Bereiche selektiv ablösen, während in den unbelichteten Bereichen nur wenig Abtrag stattfindet.

Die in den Beispielen und Vergleichsbeispielen genannten Teile und Prozente sind, soweit nicht anders angegeben, Gewichtsteile und Gewichtsprozente.

### Beispiel 1

Eine Photoresistlösung wird aus 10 Teilen Tris-(4-t-butoxicarbonyloxiphenyl-)sulfoniumhexafluoroarsenat, 90 Teilen eines Copolymerisats aus 70 Mol.% p-Hydroxistyrol und 30 Mol.% tert.-Butoxicarbonyloxistyrol (M̅ₙ (GPC) ca. 25 000) und 400 Teilen Methyl-propylenglykolacetat hergestellt. Die Lösung wird anschließend durch ein Filter mit einem Porendurchmesser von 0,2 µm filtriert und auf einem Siliziumwafer mit einem SiO₂-Film in einer Schichtdicke von ca. 1,0 µm aufgeschleudert. Der Wafer wird eine Minute bei 90°C getrocknet und anschließend mit einer bildmäßig strukturierten Testmaske im Kontaktverfahren 3 Sekunden mit Excimer-Laserlicht der Wellenlänge 248 nm belichtet. Danach wird 60 Sekunden bei 80°C ausgeheizt und mit einem Entwickler vom pH-Wert 13,00 30 Sekunden entwickelt. Die belichteten Bereiche sind vollständig abgetragen, während kein Abtrag der unbelichteten Bereiche gemessen wird. Die Resistmuster zeigen vertikale Flanken.

### Vergleichsbeispiel 1

Eine Photoresistlösung wird aus 10 Teilen Tris-(4-t-butoxicarbonyloxiphenyl)-sulfoniumhexafluoroarsenat, 90 Teilen Poly-(p-hydroxystyrol) und 400 Teilen Methylpropylenglykolacetat hergestellt. Es wird wie in Beispiel 1 verfahren. Die belichteten Bereiche lassen sich auch hier während der 30 Sekunden Entwicklungszeit vollständig abtragen, jedoch findet ein unerwünschter erheblicher Abtrag der unbelichteten Bereiche (52 %) statt.

Um den Abtrag in den unbelichteten Bereichen zu reduzieren, kann man den Anteil der Sulfoniumsalze erhöhen. Daher wurde eine Photoresistlösung aus 20 Teilen Tris-(4-t-butoxicarbonyloxi-phenyl-)sulfoniumhhexafluoroarsenat, 80 Teilen Poly-(p-hydroxistyrol) und 300 Teilen Methylpropylenglykolacetat hergestellt. Es wird wie in Beispiel 1 verfahren, jedoch muß man 11 Sekunden belichten, um die belichteten Bereiche unter den gleichen Bedingungen vollständig abzutragen. Die Resistprofile weisen nicht erwünschte schräge Kanten auf.

### Vergleichsbeispiel 2

Dieses Vergleichsbeispiel zeigt, daß die Verwendung von kommerziell erhältlichen Sulfoniumsalzen (ohne säurelabile Gruppen), ebenfalls nicht die erwünschte Reduzierung des Dunkelabtrages auf Werte kleiner 5 % erfüllt.

Eine Photoresistlösung wird aus 10 Teilen Triphenylsulfoniumhexa-fluoroarsenat, 90 Teilen des in Beispiel 1 genannten Copolymerisats aus 70 Mol .% p-Hydroxistyrol und 30 Mol.% tert.-Butylcarbonyloxistyrol und 400 Teilen Methylpropylenglykolacetat hergestellt. Die Lösung wird anschließend durch ein Filter mit einem Porendurchmesser von 0,2 µm filtriert und auf einen Siliziumwafer mit einem SiO₂-Film in einer Schichtdicke von 1,15 µm aufgeschleudert, Der Wafer wird eine Minute bei 90°C getrocknet und dann mit einem Entwickler vom pH-Wert 13,0 während 30 Sekunden behandelt. Es findet erheblicher Abtrag der unbelichteten Bereiche (35 %) statt.

### Beispiel 2

Eine Photoresistlösung wird aus 15 Teilen Bis-(4-t-butoxicarbonyloxiphenyl)-4-hydroxiphenyl-sulfoniumhexafluoroarsenat, 85 Teilen eines Copolymerisats aus 82 Mol.% p-Hydroxistyrol und 18 Mol.% 4-t-Butoxicarbonyloxistyrol (M̅ₙ ca. 22 000) und 400 Teilen Methylpropylenglykol-acetat hergestellt und durch einen Filter mit der Porenweite 0,2 µm filtriert. Die Photoresistlösung wird mit 5060 Umdrehungen/min auf einen oxidierten Siliziumwafer aufgeschleudert. Es resultiert nach dem Ausheizen während 5 Minuten bei 80°C eine Schichtdicke von 1,03 µm. Danach wird der Wafer durch eine Testmaske mit Excimer-Laserlicht der Wellenlänge 248 nm 5 Sekunden belichtet und 1 Minute bei 90°C ausgeheizt. Entwickelt man 30 Sekunden mit einem wäßrigen Entwickler, der 32 % Triethanolamin und 10 % Isopropanol enthält, so sind die belichteten Bereiche vollständig entfernt, während der Abtrag in den unbelichteten Bereichen 3,6 % beträgt.

### Beispiel 3

Eine Photoresistlösung wird aus 7,5 Teilen Tris-(4-t-butoxicarbonyloxiphenyl-)sulfoniumhexafluoroarsenat und 92,5 Teilen eines Copolymerisats aus 70 Mol.% p-Hydroxistyrol und 30 Mol.% 4-t-Butoxicarbonyloxistyrol (M̅ₙ ca. 25 000 g/mol aus GPC-Analyse) und 400 Teilen Methylpropylenglykolacetat hergestellt und durch einen Filter mit der Porenweite 0,2 µm filtriert. Die Photoresistlösung wird auf einen oxidierten Siliziumwafer so aufgeschleudert, daß nach dem Ausheizen während 5 Minuten bei 80°C eine Schichtdicke von 1 µm resultiert. Danach wird der Wafer durch eine Testmaske mit Excimer-Laserlicht der Wellenlänge 248 nm 5 Sekunden belichtet und 1 Minute bei 90°C ausgeheizt. Entwickelt man 30 Sekunden mit einem wäßrigen Entwickler, der 32 % Triethanolamin und 10 % Isopropanol enthält, so sind die belichteten Bereiche vollständig entfernt, während der Abtrag in den unbelichteten Bereichen 1 % beträgt.

## Patentansprüche

1. Strahlungsempfindliches Gemisch, enthaltend
(a) ein in Wasser unlösliches, in wäßrig-alkalischen Lösungen lösliches polymeres Bindemittel und
(b) ein monomere organische Verbindung, deren Löslichkeit in einem wäßrig-alkalischen Entwickler durch Einwirkung von Säure erhöht wird, und die mindestens eine durch Säure spaltbare Gruppierung sowie zusätzlich eine Gruppierung, die unter Einwirkung von Strahlung eine starke Säure bildet, enthält,
dadurch gekennzeichnet, daß das polymere Bindemittel (a) 5 bis 35 Mol.% Monomereneinheiten mit säurelabilen Gruppierungen einpolymerisiert oder einkondensiert, oder die säurelabilen Gruppierungen durch polymeranaloge Umsetzung eingeführt enthält, wobei Gruppierungen 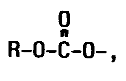 worin R 5 bis 9 Kohlenstoffatome enthält, ausgenommen sind.

2. Strahlungsempfindliches Gemisch nach Anspruch 1, dadurch gekennzeichnet, daß die säurelabilen Gruppierungen des polymeren Bindemittels (a) tert.-Butylester-, t-Butylcarbonat- und/oder Silylethergruppierungen sind.

3. Strahlungsempfindliches Gemisch nach einem der vorhergehenden Ansprüche, dadurch gekennzeichnet, daß das polymere Bindemittel (a) ein säurelabile Gruppierungen enthaltendes phenolisches Harz ist.

4. Strahlungsempfindliches Gemisch nach Anspruch 3, dadurch gekennzeichnet, daß das phenolische Harz ein säurelabile Gruppierungen enthaltender Novolak ist.

5. Strahlungsempfindliches Gemisch nach Anspruch 3, dadurch gekennzeichnet, daß das phenolische Harz ein Copolymeres von p-Hydroxistyrol und/oder p-Hydroxi-α-methylstyrol mit säurelabilen Gruppierungen tragenden Monomeren ist.

6. Strahlungsempfindliches Gemisch nach einem der Ansprüche 1 oder 2, dadurch gekennzeichnet, daß das polymere Bindemittel (a) ein Methylmethacrylat/Methacrylsäure/tert.-Butylmethacrylat-Copolymerisat ist.

7. Strahlungsempfindliches Gemisch nach einem der vorhergehenden Ansprüche, dadurch gekennzeichnet, daß es als monomere organische Verbindung (b) mindestens eine Verbindung der allgemeinen Formel (I) enthält 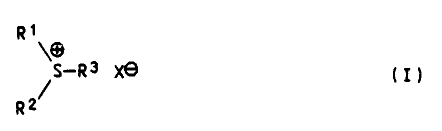 worin R¹, R² und R³ untereinander gleich oder verschieden sind und für aliphatische und/oder aromatische Reste, die gegebenenfalls Heteroatome enthalten, stehen oder zwei der Reste R¹ bis R³ miteinander zu einem Ring verknüpft sind, mit der Maßgabe, daß mindestens einer der Reste R¹ bis R³ mindestens eine durch Säure spaltbare Gruppierung enthält, wobei einer der Reste R¹ bis R³ mit einem oder mehreren weiteren Sulfoniumsalzresten, gegebenenfalls über durch Säure abspaltbare Gruppierungen, verknüpft sein kann, und X^{⊖} ein nichtnukleophiles Gegenion bedeutet.

8. Strahlungsempfindliches Gemisch nach einem der vorhergehenden Ansprüche, dadurch gekennzeichnet, daß die monomere organische Verbindung (b) ein Dimethyl-4-t-butoxicarbonyloxiphenyl-sulfoniumsalz, ein Phenyl-bis-(4-t-butoxicarbonyl-oxiphenyl)-sulfoniumsalz, ein Tris-(4-t-butoxicarbonyloxiphenyl)-sulfoniumsalz oder ein 1-Naphthyl-4-trimethylsilyloxitetramethylen-sulfoniumsalz mit Hexafluoroarsenat, Hexafluoroantimonat, Hexafluorophosphat und/oder Tetrafluoroborat als Gegenion ist.

9. Verfahren zur Herstellung von Reliefmustern und Reliefbildern, dadurch gekennzeichnet, daß man strahlungsempfindliche Gemische nach einem der vorhergehenden Ansprüche verwendet.

10. Verfahren zur Herstellung von Reliefmustern nach Anspruch 9, dadurch gekennzeichnet, daß nach der Belichtung auf Temperaturen zwischen 60 und 120°C erhitzt wird.

## Claims

1. A radiation sensitive mixture comprising
(a) a polymeric binder which is insoluble in water but soluble in aqueous alkaline solutions and
(b) a monomeric organic compound whose solubility in an aqueous alkaline developer is increased by the action of acid and which contains at least one acid cleavable group and additionally a group which forms a strong acid on irradiation,
wherein the polymeric binder (a) contains from 5 to 35 mol % of monomer units having acid labile groups as copolymerized or cocondensed units or the acid labile groups introduced by polymer analogous reaction, with the exception of 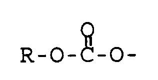 groups where R contains 5-9 carbon atoms.

2. A radiation sensitive mixture as claimed in claim 1, wherein the acid labile groups of polymeric binder (a) are tert-butyl ester, t-butyl carbonate and/or silyl ether groups.

3. A radiation sensitive mixture as claimed in either of the preceding claims, wherein polymeric binder (a) is a phenolic resin containing acid labile groups.

4. A radiation sensitive mixture as claimed in claim 3, wherein the phenolic resin is a novolak containing acid labile groups.

5. A radiation sensitive mixture as claimed in claim 3, wherein the phenolic resin is a copolymer of p-hydroxystyrene and/or p-hydroxy-α-methylstyrene with a monomer that carries acid labile groups.

6. A radiation sensitive mixture as claimed in claim 1 or 2, wherein polymeric binder (a) is a methyl methacrylate/methacrylic acid/tert-butyl methacrylate copolymer.

7. A radiation sensitive mixture as claimed in any of the preceding claims, containing as monomeric organic compound (b) at least one compound of the general formula (I) 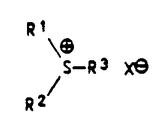 where R¹, R² and R³ are identical to or different from one another and each is singly acyclyl or aryl which may contain heteroatoms, or two of R¹ to R³ together form a ring, with the proviso that at least one of R¹ to R³ contains one or more acid cleavable groups, one of R¹ to R³ can be linked to one or more further sulfonium salt residues directly or via acid cleavable groups, and X⁻ is a nonnucleophilic counterion.

8. A radiation sensitive mixture as claimed in any of the preceding claims, wherein monomeric organic compound (b) is a dimethyl-4-t-butoxycarbonyloxyphenyl-sulfoniumsalt, a phenylbis(4-t-butoxycarbonyloxyphenyl)-sulfonium salt, a tris(4-t-butoxycarbonyloxyphenyl)-sulfonium salt or a 1-naphthyl-4-trimethylsilyloxytetra-methylenesulfonium salt with hexafluoroarsenate, hexafluoroantimonate, hexafluorophosphate and/or tetrafluoroborate as counterion.

9. A process for producing relief patterns and relief images, which comprises using a radiation sensitive mixture as claimed in any of the preceding claims.

10. A process for producing relief patterns as claimed in claim 9, wherein irradiation is followed by heating to from 60 to 120°C.

## Revendications

1. Mélange sensible aux rayonnements contenant
a) un liant polymère insoluble dans l'eau mais soluble dans les solutions aqueuses alcalines, et
b) un composé organique monomère dont la solubilité dans un révélateur aqueux alcalin est accrue sous l'action d'un acide et qui contient au moins un groupement scindable par les acides et en outre un groupement formant un acide fort sous l'action des rayonnements,
caractérisé par le fait que le liant polymère a) contient à l'état polymérisé ou condensé de 5 à 35 mol % de motifs monomères à groupements instables aux acides, ou bien les groupements instables au acides ont été introduits par réaction analogue au polymère, les groupements 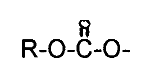 dans lesquels R contient de 5 à 9 atomes de carbone, étant exclus.

2. Mélange sensible aux rayonnements selon la revendication 1, caractérisé en ce que les groupements instables aux acides du liant polymère a) sont des groupements ester tert-butylique, t-butylcarbonate et/ou éther silylique.

3. Mélange sensible aux rayonnements selon une des revendications qui précèdent, caractérisé en ce que le liant polymère a) est une résine phénolique contenant des groupements instables aux acides.

4. Mélange sensible aux rayonnements selon la revendication 3, caractérisé en ce que la résine phénolique est une novolaque contenant des groupements instables aux acides.

5. Mélange sensible aux rayonnements selon la revendication 3, caractérisé en ce que la résine phénolique est un copolymère du p-hydroxystyrène et/ou du p-hydroxy-alpha-méthylstyrène et de monomères portant des groupements instables aux acides.

6. Mélange sensible aux rayonnements selon l'une des revendications 1 ou 2, caractérisé en ce que le liant polymère a) est un copolymère méthacrylate de méthyle/acide méthacrylique/méthacrylate de tert-butyle.

7. Mélange sensible aux rayonnements selon l'une des revendications qui précèdent, caractérisé en ce qu'il contient en tant que composé organique monomère b) au moins un composé de formule générale I 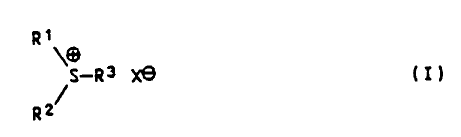 dans laquelle R¹, R² et R³, ayant des significations identiques ou différentes, représentent des radicaux aliphatiques et/ou aromatiques contenant le cas échéant des hétéroatomes, ou bien deux des groupes R¹ à R³ sont reliés entre eux avec formation d'un cycle, sous réserve que l'un au moins des groupes R¹ à R³ contient au moins un groupement scindable par les acides, l'un des groupes R¹ à R³ pouvant être relié à un ou plusieurs autre radicaux de sels de sulfonium, éventuellement par l'intermédiaire de groupements instables aux acides, et X^{⊖} représente un ion correspondant non nucléophile.

8. Mélange sensible aux rayonnements selon l'une des revendicactions qui précèdent, caractérisé en ce que le composé organique monomère b) est un sel de diméthyl-4-tert-butoxycarbonyloxyphényl-sulfonium, un sel de phényl-bis-(4-tert-butoxycarbonyl-oxy-phényl)sulfonium, un sel de tris-(4-tert-butoxycarbonyloxyphényl)-sulfonium ou un sel de 1-naphtyl-4-triméthylsilyloxytétraméthylène-sulfonium avec ion correspondant hexafluoroarséniates, hexafluoroantimoniates, hexafluorophosphate et/ou tétrafluoroborate.

9. Procédé pour la fabrication de modèles en relief et images en relief, caractérisé en ce que l'on utilise des mélanges sensibles aux rayonnements selon une des revendications qui précèdent.

10. Procédé pour la fabrication de modèles en relief selon la revendication 9, caractérisé en ce que, après exposition à la lumière, on chauffe à des températures de 60 à 120 °C.
